# EUROPÄISCHE PATENTSCHRIFT

(11) **EP 2 171 838 B1**
(45) Veröffentlichungstag und Bekanntmachung des Hinweises auf die Patenterteilung: **15.08.2012**
(21) Anmeldenummer: 08773534.6
(22) Anmeldetag: 19.06.2008
(51) Int. Cl.: H03C 1/02, H03C 1/06, H03K 7/02

(54) **VERFAHREN UND VORRICHTUNG ZUR ERZEUGUNG EINES AMPLITUDEN-MODULIERTEN SIGNALS**
METHOD AND DEVICE FOR PRODUCING AN AMPLITUDE-MODULATED SIGNAL
PROCÉDÉ ET DISPOSITIF DE PRODUCTION D'UN SIGNAL À MODULATION D'AMPLITUDE

(30) Priorität: 21.06.2007 DE 102007028695
(43) Veröffentlichungstag der Anmeldung: 07.04.2010
(73) Patentinhaber: Kathrein-Austria Ges.M.B.H., 6330 Kufstein (AT)
(72) Erfinder: SCHÖNINGER, Bernd, A-6330 Kufstein (AT)
(74) Vertreter: Flach, Dieter Rolf Paul
(86) Internationale Anmeldenummer: PCT/EP2008/004952
(87) Internationale Veröffentlichungsnummer: WO 2008/155121

(56) Entgegenhaltungen:
- EP-A- 1 560 329
- US-A- 5 164 678
- US-B1- 6 236 837
- US-B1- 7 106 806
- US-B2- 6 960 956

## Beschreibung

Die Erfindung betrifft ein Verfahren und eine Vorrichtung zur Erzeugung eines amplituden-modulierten Signals nach dem Oberbegriff des Anspruches 1 bzw. 8.

In vielen technischen Bereichen ist es notwendig, ein moduliertes Signal zu erzeugen, das bestimmte Eigenschaften, d.h. insbesondere bestimmte Frequenzeigenschaften aufweisen und/oder Frequenzbedingungen erfüllen soll.

So ist es beispielsweise in der Nachrichten- wie aber auch allgemein in der informationsübertragenden Technik üblich, ein Nutz- oder Informationssignal (welches nachfolgend teilweise auch als Modulationssignal bezeichnet wird) durch Veränderung, also Modulation eines sog. Trägersignals zu übertragen, also das Nutz- oder Informationssignal für die Übertragung über ein bestimmtes Medium in ein geeignetes Frequenzband umzusetzen. Anhand der übertragenen Eingangssignale kann man beispielsweise analoge und digitale Modulationsverfahren unterscheiden.

Je nach Modulationsverfahren unterscheidet man beispielsweise zwischen Amplituden-, der Frequenz- oder der Phasenmodulation.

Allen vorstehend genannten Verfahren ist dabei gemeinsam, dass das Nutz- und/oder Informationssignal (also das Modulationssignal) in einen anderen Frequenzbereich umgesetzt wird. Dabei können Parameter wie die Amplitude, die Frequenz oder die Phase des Trägersignals durch das Nutzsignal variiert werden. In Abhängigkeit des angewendeten Verfahrens werden gegebenenfalls nur einzelne Parameter des Trägersignals oder alle Parameter verändert.

Bei der analogen Amplitudenmodulation erfolgt beispielsweise nur eine Variation der Amplitude des Trägersignals, während die anderen Parameter der Trägerfrequenz keine Information tragen.

Die Modulation von elektromagnetischen Wellen kann, wie erwähnt, in unterschiedlichsten technischen Bereichen Anwendung finden, beispielsweise auf dem Gebiet der Radio, Fernseh-, Satellitenfernseh- oder digitalen Fernseh-Technik, auf dem Gebiet der leitungsgebundenen wie leitungsfreien Übertragung in Datennetzen, in Funk-, Mobil-und Satellitentelefonen usw.

Ein anderes Anwendungsgebiet ist beispielsweise der Bereich der Funkidentifikation (RFID) und verwandter Gebiete.

Bei der RFID-Technik handelt es sich bekanntermaßen um ein Verfahren zur automatischen Identifikation von Gütern aller Art, bei Bedarf aber auch von Personen. Es handelt sich dabei um eine berührungslose Identifizierung, bei der die zu überwachenden Gegenstände oder Personen mit einem Transponder, im speziellen mit einem sog. RFID-Tag versehen sind, die Informationen beinhalten, die den Gegenstand kennzeichnen. Ferner ist ein Lesegerät zum Auslesen der Tag-Informationen (Transponder-Kennung) vorgesehen. Bevorzugt werden derartige RFID-Tags in einem Nahfeld einer Antenne eines Lesegerätes eingesetzt, so dass die über das Antennenfeld ausgestrahlte Energie benutzt werden kann, die in den Transpondern abgespeicherte Informationen auszulesen, obgleich die passiven Transponder mit keiner eigenen Energieversorgung ausgestattet sind. Ansonsten müssen Transponder - wenn sie außerhalb eines Nahfeldes einer Antenne angeordnet sind - mit einer eigenen Stromquelle versehen sein. Zudem muss angemerkt werden, dass beim Beschreiben von Tags ein nochmals höhere Leistung benötigt wird, verglichen mit dem Auslesen von Tags.

Beim Einsatz der RFID-Technik (wie aber auch in vielen anderen Technikbereichen und -gebieten) bestehen entsprechende Normen und Grenzbedingungen, die eingehalten werden müssen.

So ist es beispielsweise in der RFID-Technik eine der standardisierten Voraussetzungen, dass das Nutzband, also die Bandbreite des modulierten Signals, eine bestimmte Größe nicht übersteigen darf. Eine insoweit einschränkende Bedingung kann lauten, dass die Bandbreite 250 kHz nicht übersteigen darf. Ferner soll beispielsweise ein bestimmter Modulationsgrad nicht unterschritten werden, beispielsweise ein Modulationsgrad von 80 %. Bei dem Modulationsgrad handelt es sich bekanntermaßen um eine Angabe, wie stark das zu modulierende Nutzsignal die Amplitude des modulierten Signals beeinflussen darf.

Weitere Bedingungen sind beispielsweise, dass außerhalb des Nutzbandes das Spektrum eine bestimmte Signalgröße nicht überschreiten darf. Auf dem Gebiet der RFID-Technik ist dabei beispielsweise die Norm ETSI EN 300 220-1 einzuhalten, die besagt, dass außerhalb des Nutzbandes das Spektrum kleiner als -36 dBm sein muss. Ferner kann eine weitere Bedingung insoweit bestehen, dass beispielsweise ein rechteckförmiges oder rechteckförmig angenähertes Nutz- oder Informationssignal erzeugt und die entsprechende Trägerfrequenz entsprechend moduliert werden soll, wobei für die Modulationsfrequenz des Rechtecksignals eine bestimmte Frequenz oder eine bestimmte Oberfrequenz von beispielsweise 40 kHz vorgeschrieben sind.

Auf dem angesprochenen Gebiet ist beispielsweise auch die "Specification for RFID Air Interface EPC™ Radio-Frequency Identity Protocols Class-1 Generation-2 UHF RFIC Protocol for Communications at 860 MHz - 960 MHz" einzuhalten.

Da das Rechtecksignal jedoch eine nicht zu vernachlässigende Welligkeit sowie eine Reihe von Oberschwingungen in der Regel oberhalb des zulässigen Nutzbandes aufweist, kann die Trägerleistung des Trägersignals nicht beliebig gesteigert werden, da ansonsten außerhalb des zulässigen Nutzbandes (also außerhalb der zulässigen Bandbreite) in dem unzulässigen Bereich die Vorgaben für die Dämpfung des Signals nicht eingehalten werden kann. Mit Verringerung der Signalleistung des Trägersignals jedoch verringert sich auch die Reichweite, innerhalb der die passiven Tags mit ausreichender Energie zum Auslesen der Informationen versorgt werden können.

Um also die Trägerleistung des Trägersignals gleichwohl zu erhöhen, ist bereits vorgeschlagen worden, der Signalerzeugungs-Einheit (mit der beispielsweise ein Rechteckimpuls oder ein anderer Impuls bestimmter Form erzeugt wird) eine ein- oder mehrstufige Tiefpassfilter-Schaltung nachzuschalten, um die auftretenden Oberwellen so stark zu dämpfen, dass die jeweils gültigen Normen zur Übertragung eines Trägersignals z.B. in einen Bandpassbereich eingehalten werden können. Mit anderen Worten kann also die Trägerleistung des Trägersignals nur so weit erhöht werden, dass die vorhandenen Normen zumindest gerade noch erfüllt werden.

Ferner ist aus der EP 1 560 329 A ein Vorverzerrer als bekannt zu entnehmen, bei welchem eine Linearisierung des Ausgangssignals des Leistungsverstärkers durchgeführt wird. Eine Untersuchung unter Bewertung der vorhandenen Oberwellen im Ausgang des Amplituden-Modulators findet nicht statt.

Aus der US 6 236 837 B1 ist ebenfalls ein Vorverzerrer für eine Linearisierung in einem Radiofrequenz-Leistungsverstärker beschrieben, der unter anderem einen Modulator umfasst.

Geräte und Verfahren zur verbesserten Aussteuerung in der Linearität bei Leistungsverstärkern und zur Verminderung der Verzerrung sind darüber hinaus grundsätzlich auch aus der US 5 164 678 A, der US 6 960 956 B2 sowie der US 7 106 806 B1 zu entnehmen.

Demgegenüber ist es Aufgabe der vorliegenden Erfindung, ein verbessertes System, d.h. ein verbessertes Verfahren sowie eine verbesserte Vorrichtung zur Erzeugung eines amplituden-modulierten Signals zu schaffen, das an vorgegebene bestehende Bedingungen, insbesondere Grenzbedingungen optimal angepasst und dabei in einem zulässigen Übertragungsbereich mit gegenüber herkömmlichen Lösungen deutlich höherer Leistung, also höherem Signalpegel erzeugt und/oder ausgestrahlt werden kann.

Die Aufgabe wird erfindungsgemäß bezüglich des Verfahrens entsprechend den im Anspruch 1 und bezüglich der Vorrichtung entsprechend den im Anspruch 8 angegebenen Merkmalen gelöst. Vorteilhafte Ausgestaltungen der Erfindung sind in den Unteransprüchen angegeben.

Im Gegensatz zu herkömmlichen Lösungen wird nunmehr erfindungsgemäß vorgeschlagen, die an bestimmte Grenzbedingungen oder Zulässigkeitsbedingungen angepasste Nutz- oder Informationssignale, also ein sog. "Wunsch-Signal", aus digitalisierten, vorzugsweise hinterlegten und/oder abgespeicherten Daten zu erzeugen, und das so generierte digitale Signal mittels einer Digital-/Analog-Wandlung in ein analoges Signal zu wandeln. Damit nun dieses in ein analoges Signal gewandelte Signal die auf dem gegebenen Einsatzgebiet vorhandenen Bedingungen erfüllt, wird dieses Signal nunmehr primär nicht einer weiteren Signalformung (beispielsweise unter Verwendung eines Tiefpasses zum Unterdrücken von Oberwellen) unterzogen, sondern die Daten für das digitalisierte Nutz- oder Informationssignal sind zuvor so verändert und/oder gebildet und/oder ausgewählt worden, dass das nach der Digital-Analog-Wandlung vorliegende analoge Nutz- oder Informationssignal möglichst exakt die vorgegebenen Bedingungen einhält und/oder erfüllt.

Im Rahmen der Erfindung wird zur Festlegung des digitalisierten Ausgangssignals eine Fourier-Transformation (FT), insbesondere eine sog. schnelle Fourier-Transformation (FFT) durchgeführt, also ein Algorithmus zur schnellen Berechnung der Werte einer diskreten Fourier-Transformation (DFT) angewendet, also ein Verfahren, bei dem die Anzahl der Stützstellen bzw. Abtastpunkte eine Zweierpotenz ist. Durch diese Fourier-Transformation lässt sich ein Spektrogramm, also ein sog. Amplituden-Spektrogramm umfassend die Grund- oder Fundamentalschwingung und die zugehörigen Oberschwingungen mit den zugehörigen Amplituden bezüglich der jeweiligen Frequenzanteile ermitteln. In diesem Rahmen kann nunmehr festgelegt werden, welche Spektralanteile (Oberwellen) zulässig sind und welche Oberwellen (Frequenzanteile) gänzlich oder mit entsprechend "manipulierbarer Amplitude" zugelassen werden können. Somit kann also genau ein Signal erzeugt werden, das die entsprechenden Bedingungen bezüglich eines zulässigen Nutzbandes (Bandbreite) und eines nicht zulässigen Bereiches einhält.

In einer besonders bevorzugten Ausführungsform der Erfindung kann dabei auch das Schaltungsumfeld beispielsweise einschließlich eines Modulators, eines vorgesehenen Nieder-Frequenz- und/oder Hochfrequenzverstärkers oder bezüglich Verstärkerstufen, einer Senderstufe, eines gegebenenfalls weiterhin vorgesehenen Bandpasses, Tiefpasses und dergleichen mit berücksichtigt werden, da diese Baugruppen grundsätzlich ebenfalls dazu beitragen, dass gegebenenfalls gewisse Oberwellen entstehen, die in einem an sich nicht zulässigen Bereich liegen. Das Gleiche gilt grundsätzlich auch bezüglich der Analogisierung des Nutz- oder Informationssignals bei der Digital-Analog-Wandlung. Bei der Digital-Analog-Wandlung erhält man ein analoges Signal, welches durch eine Vielzahl von Treppenstufen entsprechend der gewählten Auflösung gekennzeichnet ist, wodurch ebenfalls wieder Oberschwingungen erzeugt werden, die durch einen bevorzugt vorgesehenen Bandpass oder Tiefpass (bei entsprechenden Anforderungen auch Hochpass) weiter unterdrückt werden können.

Durch eine erfindungsgemäß bevorzugt vorgesehene Optimierung des entsprechenden digitalisierten Ausgangssignals können nunmehr durch Anwendung an sich bekannter Optimierungsverfahren die digitalisierten Werte des Ausgangssignals so verändert werden, dass das letztlich nach der Analogisierung des digitalisierten Signals vorliegende Signal die vorgegebenen Bedingungen in noch besserer Weise erfüllt. Die Optimierung kann dadurch erreicht werden, dass stets der Zeitschlitz (also die Zeitdauer einer jeden Treppenstufe des analogisierten Signals) sowie die jeweilige Höhe der zugehörigen Stufe (also bezüglich des jeweiligen einzelnen Zeitschlitzes) geändert wird, um dann zu überprüfen, ob das erhaltene Ausgangssignal im Sinne der gewünschten Optimierung verbessert oder verschlechtert wurde.

Die entsprechende Optimierung muss nicht anhand eines realen Schaltungsaufbaus für den gesamten Optimierungsvorgang durchgeführt werden. Bevorzugt genügt es, eine Messung an einer entsprechenden Modulations- oder Sendeeinrichtung durchzuführen, um alle wesentlichen Daten zu ermitteln, anhand derer dann eine Optimierung in einem Simulierungsverfahren auf einem Rechner durchgeführt werden kann. Die darüber ermittelbaren Daten und Werte können dann für alle entsprechend aufgebauten Modulations-und/oder Sendeeinrichtungen verwendet werden. Es ist also keine permanente Echtzeitoptimierung notwendig.

Besonders günstig erweist sich an dem erfindungsgemäßen Verfahren sowie der erfindungsgemäßen Vorrichtung, dass die Optimierung unter Berücksichtigung der gesamten Schaltung letztlich nur einmal berechnet werden muss. Die dann erzielten Daten können für jede der Schaltungsaufbauten verwendet werden.

Weitere Vorteile, Einzelheiten und Merkmale der Erfindung werden nachfolgend anhand eines Ausführungsbeispieles unter Bezugnahme auf die beigefügten Zeichnungen näher erläutert. Dabei zeigen im Einzelnen:
- Figur 1 :: eine schematische Darstellung eines zulässigen Nutzbandes für ein zu erzeugendes amplitudenmoduliertes Rechtecksignal;
- Figur 2 :: eine vergrößerte Detaildarstellung eines Rechteckimpulses entsprechend einer auf dem Gebiet der RFID-Technik bestehenden Norm;
- Figur 3 :: ein Blockschaltbild einer Amplituden-Modelations-Schaltung nach dem Stand der Technik;
- Figur 4 :: eine entsprechende Schaltungsdarstellung gemäß der Erfindung;
- Figur 5 :: Darstellung eines gestuften analogen Nutz-oder Informationssignals;
- Figur 6 :: eine schematische Darstellung zur Signalberechnung eines korrigierten digitalisierten Nutz- oder Informationssignals;
- Figur 7 :: eine ausschnittsweise Vergrößerung des in Figur 5 beispielhaft gezeigten, aus Einzelstufen gebildeten Analogsignals zur Verdeutlichung der Manipulation einzelner Stufenlängen und/oder Stufenhöhen zum Auffinden eines optimierten korrigierten Nutz- oder Informationssignals; und
- Figur 8 :: eine Darstellung zur Erläuterung der erfindungsgemäß vorgesehenen Optimierung zur Signalberechnung.

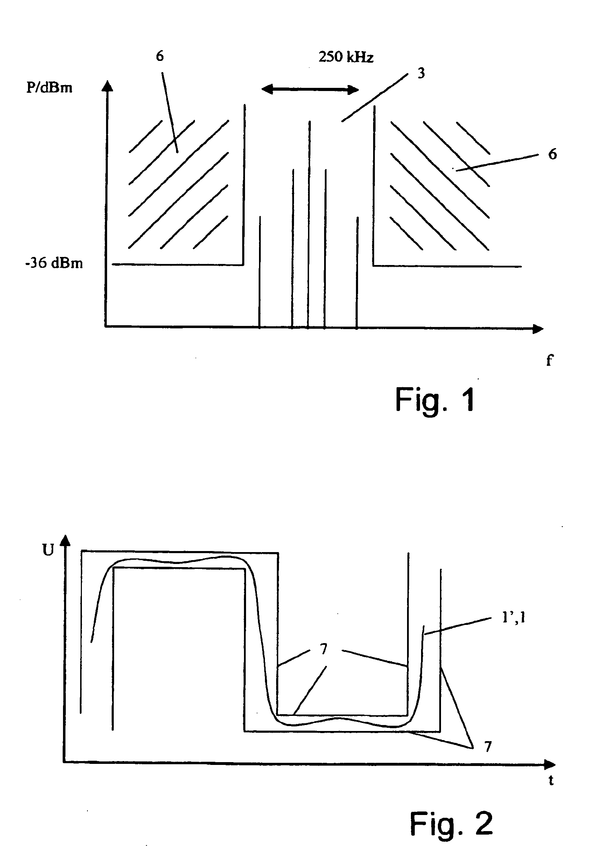

In Figur 1 ist in schematischer Wiedergabe ein Diagramm gezeigt, anhand dessen verdeutlicht werden soll, dass beispielsweise ein zu übertragendes Nutz- oder Informationssignal (also ein sog. Informationsträger) in einem Nutzband 3 mit einer Bandbreite von beispielsweise 250 kHz mittels eines sog. Trägersignals ausgesandt werden soll, also durch entsprechende Veränderungen (Modulation) eines Trägersignals. Das Nutz- oder Informationssignal (also das Modulationssignal) soll dabei auf ein Trägersignal aufmoduliert werden, und zwar gemäß einer Amplitudenmodulation.

Außerhalb des Nutzbandes 3 soll das Spektrum des modulierten Trägersignals nach einer vorgegebenen Norm oder vorgebbaren Bedingungen (beispielsweise nach der Norm ETSI EN 300-220-1) kleiner als -36 dBm sein (also bezogen auf einen Leistungspegel von 1 mW.

In Figur 1 ist dabei auf der X-Achse (Abszisse) die Frequenz f und auf der Ordinate (Y-Achse) die Leistung P/dBm wiedergegeben, und zwar bezüglich des Nutzbandes 3 und den außerhalb des Nutzbandes 3 liegenden gedämpften Bereichen 6.

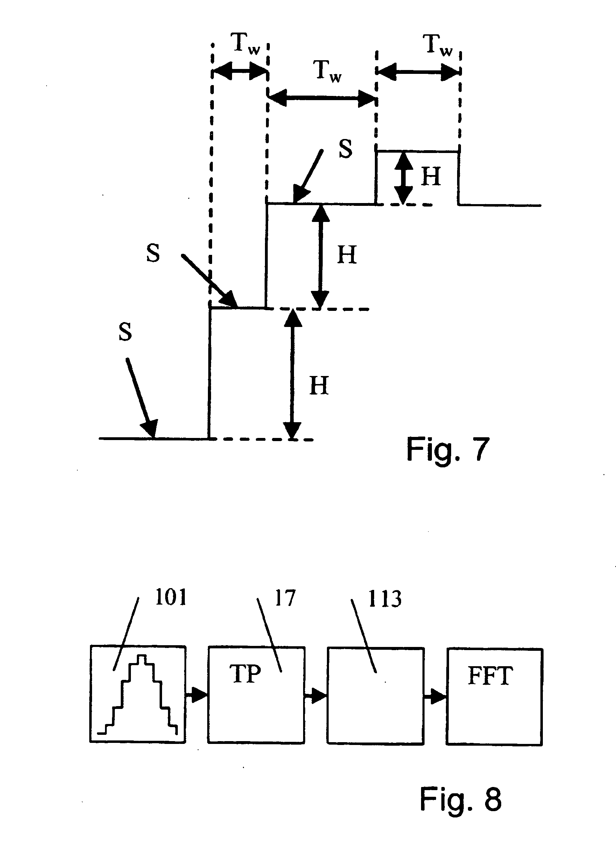

Im Bereich des Nutzbandes 3 (welches im gezeigten Ausführungsbeispiel eine Bandbreite von 250 kHz aufweist (aber auch eine andere Größe aufweisen kann) sind diskrete Spektrallinien (Spektraldiagramm) in unterschiedlicher Höhe eingezeichnet. Diese Spektrallinien beziehen sich beispielsweise bezüglich der nachfolgend noch erörterten Figur 7 auf ein 40 kHz Rechtecksignal. Wird beispielsweise ein 40 kHz Rechtecksignal erzeugt, so weist dieses Spektrallinien bei 40 kHz, 20 kHz, 200 kHz, 280 kHz etc. auf. Alle Spektrallinien über 125 kHz würden im gezeigten Ausführungsbeispiel nunmehr unterdrückt werden.

Bei anderen Frequenzen ändert sich nur die spektrale Verteilung. Genauso ergibt sich eine andere spektrale Aufteilung, wenn sich die Impulsbreite ändert und die Frequenz gleich bleibt.

In Figur 2 ist in schematischer Wiedergabe über der Zeitachse t beispielsweise der Spannungsverlauf U eines angenäherten Rechteckimpulses 1' des Nutz- oder Informationssignals 1 wiedergegeben, und zwar innerhalb der zulässigen Grenzen 7, die beispielsweise einer auf dem einschlägigen Gebiet vorgegebenen Norm entsprechen, deren Bedingungen also eingehalten werden sollen. Auf dem Gebiet der RFID-Technik kann es sich hierbei beispielsweise um die Spezifikation für "Specification for RFID Air Interface EPC™ Radio-Frequency Identity Protocols Class-1 Generation-2 UHF RFIC Protocol for Communications at 860 MHz - 960 MHz" handeln.

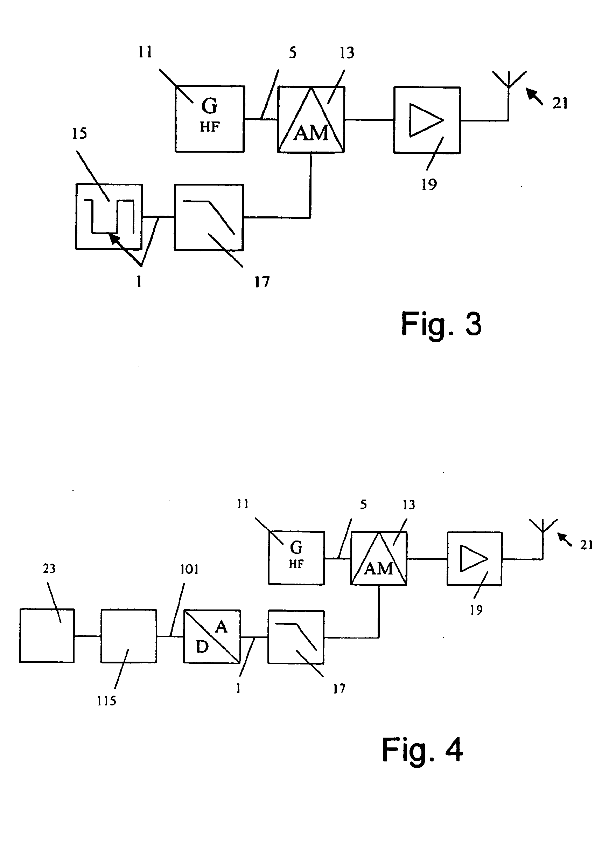

Möchte man beispielsweise ein derartiges rechteckförmiges Nutz- oder Informationssignal 1 heranziehen, um damit eine Amplitudenmodulations (AM-Modulation) eines Trägersignals durchzuführen, ist nach dem Stand der Technik hierfür in der Regel eine Schaltung entsprechend Figur 3 verwendet worden.

Gemäß Figur 3 ist zu ersehen, dass mittels eines Generators 11 ein Trägersignal 5, beispielsweise ein Hochfrequenz-Signal 5 (HF-Signal) erzeugt wird, welches einem Modulator 13 zur Durchführung der Amplitudenmodulation (AM) zugeführt wird.

Dem anderen Eingang des Modulators 13 ist beispielsweise das von einem Signal-Generator 15 erzeugte Nutz- oder Informationssignal 1 über einen nachfolgenden Tiefpass 17 zugeführt worden. Im gezeigten Ausführungsbeispiel handelt es sich um ein rechteckförmiges Nutz- oder Informationssignal 1, bei dem die Rechteckimpulslänge größer (aber auch kleiner) sein kann als die nachfolgende Pause zum nächsten Rechteckimpuls. Da das Rechtecksignal 1, 1' zahlreiche Oberwellen aufweist, die beispielsweise außerhalb des zulässigen Nutzbandes 3 liegen, ist der erwähnte Tiefpass 17 dem Nutzsignal-Generator 15 nachgeschaltet, um unzulässige Oberwellen zu dämpfen.

Dem Modulator 13 nachgeordnet ist üblicherweise auch noch ein Verstärker oder eine Verstärkerstufe 19, bevor das Signal beispielsweise einer Antenne 21 zugeführt wird. Alternativ oder ergänzend kann ein Verstärker oder eine Verstärkerstufe 19 auch zwischen dem Generator 11 und dem Modulator 13 vorgesehen sein.

An sich ist es wünschenswert, die Sendeleistung möglichst groß zu wählen, um beispielsweise auch noch weiter entfernte RFID-Tags (sog. passive Transponder) mit Energie zu versorgen, damit die auf einem Mikrochip auf dem Tag abgespeicherten Daten als Antwortsignal mittels eines Readers ausgelesen werden können. Dies gilt umso mehr für das Beschreiben von Tags, da hierzu ohnehin höhere Leistungen erforderlich sind als beim Auslesen der Tags. Die Trägerleistung kann allerdings nur so weit erhöht werden, dass die Spektrumsanforderungen eingehalten werden, also das mit dem Nutz- oder Informationssignal 1 modulierte Trägersignal 5 beispielsweise nur eine Fundamentschwingung und die zugehörigen Oberschwingungen aufweist, die innerhalb des zulässigen Nutzbandes liegen. Unter dieser Voraussetzung hängt also die maximale Sendeleistung nur von der Filtertechnik ab. Je besser die Filtertechnik ist, umso besser können die unerwünschten Oberwellen unterdrückt werden, um die betreffende Norm einzuhalten, wodurch also die Sendeleistung erhöht werden kann.

Um die Sendeleistung weiter zu erhöhen, wird in Abweichung zu der nach dem Stand der Technik bekannten Schaltung gemäß Figur 3 ein Aufbau gemäß Figur 4 im Rahmen der Erfindung vorgeschlagen, bei dem ebenfalls wieder mittels eines Generators 11 ein Trägersignal 5 erzeugt und einem Modulator 13 zugeführt wird, wobei beispielsweise zumindest ein üblicherweise vorgesehener Verstärker 19 zwischen dem Generator 11 und dem Modulator 13 und/oder zwischen dem Modulator 13 und der Antenne 21 vorgesehen ist.

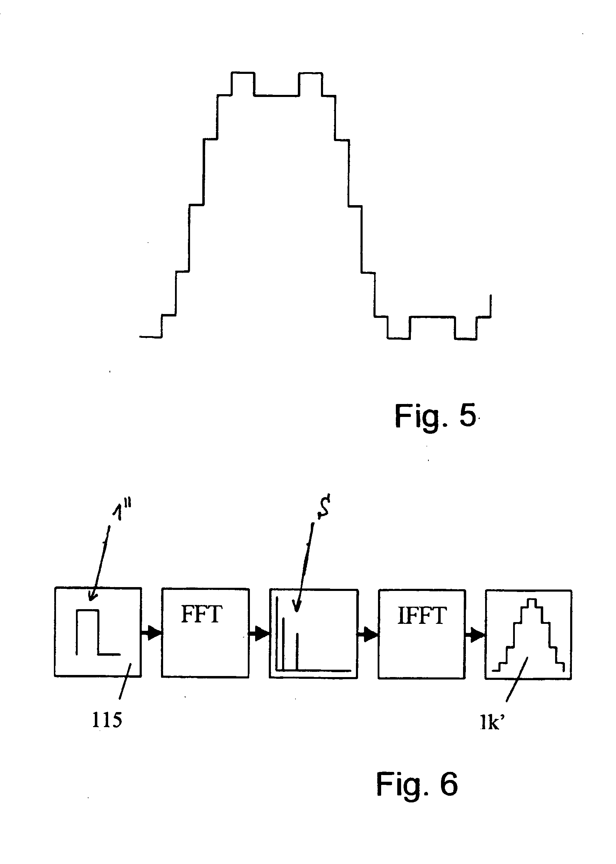

Gemäß der erfindungsgemäßen Vorrichtung ist nunmehr vorgesehen, dass das grundsätzlich einem Rechtecksignal entsprechende oder einem Rechtecksignal angenäherte Nutz-oder Informationssignal 1 nicht durch einen entsprechenden Signal-Generator 15 erzeugt wird, sondern hierzu ein digitalisiertes Nutz- oder Informationssignal 101 herangezogen wird, dessen Daten beispielsweise in einem Speicher 23 (beispielsweise in Form einer Look-up-Tabelle) abgelegt sind, die dann in einer entsprechenden Schaltungsanordnung ausgelesen werden, um ein entsprechendes digitalisiertes Nutz- oder Informationssignal 101 in einem Digital-Signalgeber 115 zu bilden. Dieses digitalisierte Nutz- oder Informationssignal 101 wird dann einem nachgeschalteten Dialog-Analog-Wandler 25 zugeführt. Dadurch wird dann ein analoges Nutz- oder Informationssignal 1 erzeugt, welches im gezeigten Ausführungsbeispiel nicht exakt rechteckförmig ist, sondern beispielsweise einem gestuften analogen Nutzsignal 1' entspricht, wie dies in Figur 5 schematisch gezeigt ist.

Dieses Signal kann nunmehr direkt oder - bevorzugt wie in Figur 4 dargestellt - ebenfalls über eine Bandpass- oder im speziellen eine Tiefpass-Schaltung 17 dem Modulator oder Mischer 13 zugeführt werden, um das Trägersignal 5 mit dem entsprechenden analogen Nutz-oder Informationssignal 1 in zumindest angenäherter Rechteckform zu modulieren und über die Antenne 21 auszustrahlen. Durch die Verwendung des Tiefpasses 17 ist sichergestellt, dass das Nutz- oder Informationssignal nach dem Tiefpass 17 nochmals weiter verbessert wird, so dass es nur mehr sehr kleine bis gar keine Oberwellen mehr außerhalb des Nutzbandes aufweist.

Die Daten für das hinterlegte digitalisierte Nutzsignal 101 werden zumindest einmal entsprechend ermittelt, wobei hierzu auf Figur 6 Bezug genommen wird.

Zur Ermittlung eines optimalen digitalisierten Nutzsignals wird von einem idealisierten Signal, einem sog. Wunsch-signal 27, ausgegangen. Im vorliegenden Ausführungsbeispiel soll dieses Wunschsignal 1" aus einem Rechteckimpuls bestehen.

Dieses Wunschsignal 1" wird einer Fourier-Transformation (FT) unterzogen, vorzugsweise einer sog. schnellen Fourier-Transformation FFT. Es handelt sich dabei bekanntermaßen um einen Algorithmus zur schnellen Berechnung der Werte einer diskreten Fourier-Transformation (DFT).

Bei der Fourier-Analyse eines Rechtecksignals würde man bekannterweise eine unendliche Reihe von Sinusschwingungen mit einer Fundamentalschwingung und einer unendlichen Reihe von Oberschwingungen erhalten. Der Rechteckimpuls umfasst dabei jeweils die ungeraden, harmonischen Oberschwingungen, wobei die Amplitude mit steigender Frequenz abnimmt.

Durch die erwähnte Fourier-Analyse oder Fourier-Transformation erhält man also ein Amplitudenspektrum S, also ein Diagramm unter Wiedergabe der Frequenzanteile mit den zugehörigen Amplituden. In Figur 6 ist dabei zwischen der Fourier-Transformation und der inversen Fourier-Transformation (IFT bzw. IFFT) das Basisband dargestellt. Nach der Amplitudenmodulation liegt das Basisband links und rechts vom Trägersignal, ist somit also doppelt so groß.

Soll jedoch das entsprechend zu modulierende Nutzsignal bestimmte Randbedingungen einhalten, beispielsweise bezüglich einer vorgegebenen Bandbreite von beispielsweise 250 kHz, so können nunmehr die zulässigen bzw. die zu unterdrückenden Oberschwingungen festgelegt werden. Gemäß dem Ausführungsbeispiel nach Figur 6 ist dargestellt, dass beispielsweise nur das Spektrum verwendet wird, dessen Frequenzanteile unterhalb von 125 kHz liegen. Die Frequenzanteile, die größer als 125 kHz sind, sollen entsprechend unterdrückt und gedämpft werden, beispielsweise auf unter -200 dBm.

Das so durch das Spektrogramm definierte Nutz- oder Informationssignal kann nunmehr im Rahmen einer inversen Fourier-Transformation (IFT), insbesondere in Form einer inversen schnellen Fourier-Transformation (IFFT) in ein entsprechendes korrigiertes, analoges Nutz- oder Informationssignal 1k transformiert werden, welches entsprechend der Darstellung gemäß Figur 7 wiederum in Zeitschlitze 33 unterteilt ist, die jeweils das gleiche Niveau, also die gleiche Spannung innerhalb eines Zeitschlitzes T_{w} aufweisen.

Mit anderen Worten wird das nunmehr korrigierte Wunsch-signal 1k' vom zulässigen Spektrum, d.h. dem zulässigen Amplitudenspektrum begrenzt und in Zeitschlitze T_{w} mit gleich bleibender Spannung zerlegt. Dabei können die Werte für die Länge der Zeitschlitze (also Länge der Stufen T_{w}) und/oder die Höhe H und damit der Abstand zwischen den einzelnen Stufen S in den Zeitschlitzen verändert, manipuliert und damit einer weiteren Optimierung unterzogen werden. Dabei ist in Figur 7 nur ein schematischer Ausschnitt eines in verschiedene Stufen aufgelösten analogen Signals wiedergegeben, wie es im Prinzip nach der Digital-Analog-Wandlung am Ausgang des Digital-Analog-Wandlers 25 erhalten wird und in Figur 5 in einem anderen Maßstab nur beispielhaft dargestellt ist.

Die Daten dieses korrigierten analogen Nutz- oder Informationssignals 1k' können in digitalisierter Form als digitales Nutz- oder Informationssignal 101 in dem erwähnten Speicher 23 hinterlegt werden.

Da allerdings bei der Dialog-Analog-Wandlung eines derartigen digitalisierten Nutzsignals in dem vorgesehenen Tiefpass und/oder in der weiteren Schaltungsanordnung einschließlich des Modulators 13 nochmals Oberwellen entstehen können, die in einem unerlaubten Bereich liegen, ist im Rahmen einer bevorzugten Ausführungsform der Erfindung eine weitere Optimierung vorgesehen.

Dazu kann beispielsweise eine Schaltungsanordnung entsprechend dem Aufbau nach Figur 4 durchgemessen werden, d.h. unter Verwendung der Daten für ein digitalisiertes Nutzsignal, welches aus den Daten eines korrigierten analogen Nutzsignals gewonnen wurde. Dabei kann in dem erwähnten Optimierungsverfahren nunmehr sowohl der Wert H (Höhe) als auch die Länge T_{w} eines Zeitschlitzes (also die Länge einer Stufe S) des in Stufenform entsprechend der vorgegebenen Auflösung erzeugten Signals verändert werden, um zu überprüfen, ob hierdurch eine Verbesserung bezüglich der Dämpfung unerwünschter Oberwellen erzielbar ist. Dieses Verfahren kann an einer konkreten Messanordnung durchgeführt werden. Ausreichend ist allerdings auch, einen konkreten Schaltungsaufbau real durchzumessen, um dann anhand der gewonnenen Daten die weitere Bearbeitung in einem Simulationsprozess an einem Rechner durchzuführen, um die weiter optimierten Daten für ein digitalisiertes Nutz- oder Informationssignal zu ermitteln.

Die erwähnte Simulation und Optimierung der entsprechenden Daten ist nur einmal notwendig. Eine derartige Realisierung zur Optimierung eines digitalisierten Ausgangssignals ist mit einem einfachen, kostengünstigen Controller möglich. Es werden keine Regelschleifen benötigt. Von daher wird auch keine große Rechenleistung im beschriebenen Modulator gemäß Figur 4 benötigt, vor allem auch kein digitaler Signalprozessor (DSP), so dass für die Schaltungsanordnung auch gemäß Figur 4 letztlich ein Low-Power-Microcontroller eingesetzt werden kann.

Wie erwähnt kann zur Durchführung der Optimierung die Länge eines jeden einzelnen Zeitschlitzes sowie die zugehörige Höhe (des stufenförmigen analogisierten Nutz- und Informationssignals) so lange manipuliert werden, bis ein verbesserter Wert zur Unterdrückung von Oberwellen gefunden wurde. Dabei wird die gesamte Schaltung stets durchgerechnet und kontrolliert, ob das durch die entsprechende Manipulation der Länge und/oder Höhe der Zeitschlitze das letztlich erhaltene Amplitudenspektrum besser oder schlechter geworden ist, und zwar bei Einhaltung aller anderen Forderungen. Auf diese Weise kann man also ein optimiertes korrigiertes Nutz- oder Informationssignal erhalten.

Anhand von Figur 8 ist ein derartiger Optimierungsprozess bzw. -aufbau schematisch dargestellt, und zwar ausgehend von einem digitalisierten Nutz- oder Informationssignal 101, dem nachgeordneten Tiefpass 17, einer Verzerrerstufe 113 zur Verzerrung des Modulators 13 und einer nachfolgenden Fourier-Transformations-Stufe FFT. Durch entsprechende Analyse der Fourier-Transformation lässt sich festlegen, ob, wie gewünscht, die betreffenden Oberwellen unterdrückt sind oder eine nur so geringe Amplitude aufweisen, dass sie den gestellten Forderungen Rechnung tragen. Für das beste Ergebnis werden dann die entsprechenden Daten des Nutz- oder Informationssignals 101 festgehalten und als Ausgangssignal für eine entsprechende, anhand von Figur 3 erläuterte Modulations- oder Sendestufe verwendet.

Die Optimierung erfolgt sowohl bei den Einzelsignalen (0, 1, RTCal, TRCal, ...) als auch bei den Summensignalen (Tag-Anfrage).

Die Durchführung dieser Optimierungsschritte kann dabei auch als "Verzerrung des Modulators" umschrieben werden.

Ist einmal bezüglich eines konkreten Schaltungsaufbaus ein optimal korrigiertes analoges Nutzsignal erzeugt worden, das keine Oberwellen im unerlaubten Bereich aufweist oder dessen Oberwellen im unerlaubten Bereich entsprechend den vorgegebenen Kriterien ausreichend stark gedämpft ist, so können die entsprechenden Daten in digitalisierter Form herangezogen und abgespeichert werden, um hierüber das entsprechende Nutzsignal stets in reproduzierender Weise aus einem Datenspeicher auszulesen und zu generieren.

Das erfindungsgemäße Verfahren zur Erzeugung eines amplituden-modulierten Signals zeichnet sich also unter anderem durch folgende Merkmale oder Schritte aus:
- ein Trägersignal (5) wird mit einem analogen Nutz-oder Informationssignal (1) amplituden-moduliert,
- das modulierte Trägersignal wird in einem Nutzband (3) mit einer vorgegebenen Bandbreite ausgesendet,
- die Trägerleistung des Trägersignals (5) wird so eingestellt, dass das Spektrum des modulierten Trägersignals außerhalb des Nutzbandes (3) einen Grenzwert für die Signalgröße des modulierten Trägersignals nicht überschreitet,
- das Nutz- oder Informationssignal (1) wird aus einem digitalisierten Nutz- oder Informationssignal (101) erzeugt, welches in ein analoges Nutz-oder Informationssignal (1) gewandelt wird,
- für das Nutz- oder Informationssignal (1) wird anstelle eines Wunschsignals (1") ein korrigiertes analoges Nutz- oder Informationssignal (1k') verwendet, das gegenüber dem Wunschsignal (1") so verändert ist, dass Oberwellen, die bei Verwendung des Wunschsignals (1") außerhalb des Nutzbandes (3) oberhalb des Grenzwertes für die Signalgröße des modulierten Trägersignals liegen, bei Verwendung des korrigierten Nutz- oder Informationssignals (1k') im zulässigen Bereich unterhalb des Grenzwertes für die Signalgröße des modulierten Trägersignals liegen.

Die erläuterte erfindungsgemäße Vorrichtung zeichnet sich unter anderem auch durch folgende Merkmale aus:
- es ist ein Generator (11) zur Erzeugung eines Trägersignals (5) vorgesehen, welches einem Modulator oder Mischer (13) zugeführt wird, der vorzugsweise mit einer Antenne (21) verbunden ist,
- es ist eine Einrichtung zur Erzeugung eines analogen Nutz- oder Informationssignals (1) vorgesehen, welche zumindest mittelbar mit einem anderen Eingang des Modulators oder Mischers (13) zur Erzeugung eines amplituden-modulierten Trägersignals verbunden ist, wobei das amplituden-modulierte Trägersignal so erzeugt wird, dass es innerhalb eines Nutzbandes (3) übertragen und außerhalb des Nutzbandes (3) ein Grenzwert für die Signalgröße nicht überschreitet,
- es ist ein Generator (115) zur Erzeugung eines digitalisierten Nutz- oder Informationssignals (101) vorgesehen,
- dem Generator (115) zur Erzeugung eines digitalisierten Nutz- oder Informationssignals (101) ist ein Digital-Analog-Wandler (25) zur Wandlung des digitalisierten Nutz- oder Informationssignals (101) in ein analoges Nutz- oder Informationssignal (1) nachgeschaltet, der direkt oder mittelbar mit dem Modulations-Eingang des Modulators oder Mischers (13) verbunden ist, und
- mittels des Generators (115) wird ein digitalisiertes Nutz- oder Informationssignals (101) und mittels des nachgeschalteten Digital-Analog-Wandlers (25) ein analoges Nutz- oder Informationssignal erzeugt, das gegenüber einem Wunschsignal (1") so verändert ist, dass Oberwellen, die bei Verwendung des Wunschsignals (1") außerhalb des Nutzbandes (3) oberhalb eines Grenzwertes für die Signalgröße des modulierten Trägersignals liegen, bei Verwendung des korrigierten Nutz- oder Informationssignals (1k') im zulässigen Bereich unterhalb des Grenzwertes für die Signalgröße des modulierten Trägersignals liegen.

Das erläuterte Verfahren und die erläuterte Vorrichtung können aber auch verwendet werden, wenn ein Nutz- oder Informationssignal verwendet wird, das eine von einem Rechteckimpuls abweichende Impulsform aufweist. Beschränkungen bezüglich der Signalform bestehen insoweit nicht. Ebenso kann nicht nur ein Nutzungsbereich, sondern mehrere versetzt zueinander liegende Nutzungsbereiche vorgesehen sein. Auch die dazwischen vorgesehenen sog. verbotenen Gebiete müssen nicht alle die gleichen Randbedingungen erfüllen. Für jedes verbotene Gebiet kann eine unterschiedliche Bedingung gegebenenfalls vorgegeben sein, wobei in all den Fällen das erfindungsgemäße Verfahren und die Vorrichtung so realisierbar ist, dass für jeden Einsatzzweck ein korrigiertes, digitalisiertes Nutz- oder Informationssignal und insbesondere auch ein insoweit optimiertes Signal vorgebbar ist, welches dann über einen Digital-Analog-Wandler in ein analoges Signal umgesetzt wird, welches dann bei der Amplitudenmodulation die gewünschten Bedingungen erfüllt.

## Patentansprüche

1. Verfahren zur Erzeugung eines amplituden-modulierten Signals mit folgenden Merkmalen:
- ein Trägersignal (5) wird mit einem analogen Nutz- oder Informationssignal (1) amplituden-moduliert,
- das modulierte Trägersignal wird in einem Nutzband (3) mit einer vorgegebenen Bandbreite ausgesendet,
- die Trägerleistung des Trägersignals (5) wird so eingestellt, dass das Spektrum des modulierten Trägersignals außerhalb des Nutzbandes (3) einen Grenzwert für die Signalgröße des modulierten Trägersignals nicht überschreitet,
**gekennzeichnet durch** die weiteren Merkmale:
- das Nutz- oder Informationssignal (1) wird aus einem digitalisierten Nutz- oder Informationssignal (101) erzeugt, welches in ein analoges Nutz- oder Informationssignal (1) gewandelt wird,
- für das Nutz- oder Informationssignal (1) wird anstelle eines Wunschsignals (1") ein korrigiertes analoges Nutz- oder Informationssignal (1k') verwendet, das gegenüber dem Wunschsignal (1") so verändert ist, dass Oberwellen, die bei Verwendung des Wunschsignals (1") außerhalb des Nutzbandes (3) oberhalb des Grenzwertes für die Signalgröße des modulierten Trägersignals liegen, bei Verwendung des korrigierten Nutz- oder Informationssignals (1k') im zulässigen Bereich unterhalb des Grenzwertes für die Signalgröße des modulierten Trägersignals liegen, und
- zur Gewinnung eines zulässigen Nutz- oder Informationssignals (101) in digitalisierter Form wird von einem Wunschsignal (1") eine Fourier-Transformation (FT, FFT), eine Festlegung des zulässigen Amplituden-Spektrums und eine inverse Fourier-Transformation (IFT, IFFT) durchgeführt, wodurch neben der Fundamentalschwingung die zulässigen Oberschwingungen zur Generierung des digitalen Nutz- oder Informationssignals (101) festlegbar sind.

2. Verfahren nach Anspruch 1, **dadurch gekennzeichnet, dass** das korrigierte analoge Nutz- oder Informationssignal-(1k') in digitalisierter Form als digitales Nutz- oder Informationssignal (101) in einem Speicher (23) hinterlegt ist, aus welchem mittels eines Generators (115) das digitalisiertes Nutz- oder Informationssignal (101) erzeugt und in einem nachgeschalteten Digital-Analog-Wandler (25) in ein analoges Nutz- oder Informationssignal (1) gewandelt wird, welches einem Trägersignal (5) aufmoduliert wird.

3. Verfahren nach Anspruch 1 oder 2, **dadurch gekennzeichnet, dass** das aus einem digitalisierten Nutz- oder Informationssignal (101) gewonnene analoge Nutz- oder Informationssignal (1) über einen Tiefpass (17) einem Modulator (13) zugeführt wird.

4. Verfahren nach einem der Ansprüche 1 bis 3, **dadurch gekennzeichnet, dass** ein gegenüber dem Wunschsignal (1") korrigiertes Nutz- oder Informationssignal (1k') in Form eines digitalisierten Nutz- oder Informationssignals (101) vorzugsweise einmalig erzeugt und in einem Speicher (23) abgespeichert wird, aus welchem nachfolgend zunächst die digitalisierten Nutz- oder Informationssignale (101) und daraus analoge Nutz- oder Informationssignals (1) erzeugt werden.

5. Verfahren nach einem der Ansprüche 1 bis 4, **dadurch gekennzeichnet, dass** ein weiterer Optimierungsschritt durchgeführt wird, bei welchem das analogisierte Nutz-oder Informationssignal (1) und/oder das modulierte Trägersignal (5) in Bezug auf zulässige und unzulässige Oberschwingungen untersucht wird, und dass das analogisierte Nutz- oder Informationssignal (1) nach der Analog-Wandlung bezüglich seiner Stufenform im Hinblick auf einzelne Zeitschlitzlängen (T_{w}) und/oder einzelne Stufenhöhen (H) verändert wird, bis eine Verbesserung bezüglich des modulierten Trägersignals im Hinblick auf zulässige und unzulässige Oberschwingungen erzielt wird, wobei die für diesen Fall gewählten Ausgangsdaten für das digitalisierte Nutz-oder Informationssignal (101) als Basisdaten zur reproduzierbaren Erzeugung eines entsprechenden digitalisierten Nutz- oder Informationssignals (1) abgespeichert werden.

6. Verfahren nach einem der Ansprüche 1 bis 5, **dadurch gekennzeichnet, dass** das in digitalisierter Form vorliegende oder erzeugte Nutz- oder Informationssignal (101) aus einem Rechteckimpuls oder einem Rechteckimpuls angenäherten Impuls besteht.

7. Verfahren nach einem der Ansprüche 1 bis 6, **dadurch gekennzeichnet, dass** das digitalisierte Nutz- oder Informationssignal (101) als Signal zur Amplitudenmodulation auf dem Gebiet der RFID-Technik verwendet wird.

8. Vorrichtung zur Erzeugung eines amplituden-modulierten Signals mit folgenden Merkmalen:
- es ist ein Generator (11) zur Erzeugung eines Trägersignals (5) vorgesehen, welches einem Modulator oder Mischer (13) zugeführt wird, der vorzugsweise mit einer Antenne (21) verbunden ist,
- es ist eine Einrichtung zur Erzeugung eines analogen Nutz- oder Informationssignals (1) vorgesehen, welche zumindest mittelbar mit einem anderen Eingang des Modulators oder Mischers (13) zur Erzeugung eines amplituden-modulierten Trägersignals verbunden ist, wobei das amplituden-modulierte Trägersignal so erzeugt wird, dass es innerhalb eines Nutzbandes (3) übertragen und außerhalb des Nutzbandes (3) ein Grenzwert für die Signalgröße nicht überschreitet,
**gekennzeichnet durch** die weiteren Merkmale:
- es ist ein Generator (115) zur Erzeugung eines digitalisierten Nutz- oder Informationssignals (101) vorgesehen,
- dem Generator (115) zur Erzeugung eines digitalisierten Nutz- oder Informationssignals (101) ist ein Digital-Analog-Wandler (25) zur Wandlung des digitalisierten Nutz- oder Informationssignals (101) in ein analoges Nutz- oder Informationssignal (1) nachgeschaltet, der direkt oder mittelbar mit dem Modulations-Eingang des Modulators oder Mischers (13) verbunden ist,
- mittels des Generators (115) wird ein digitalisiertes Nutz- oder Informationssignals (101) und mittels des nachgeschalteten Digital-Analog-Wandlers (25) ein analoges Nutz- oder Informationssignal erzeugt, das gegenüber einem Wunschsignal (1") so verändert ist, dass Oberwellen, die bei Verwendung des Wunschsignals (1") außerhalb des Nutzbandes (3) oberhalb eines Grenzwertes für die Signalgröße des modulierten Trägersignals liegen, bei Verwendung des korrigierten Nutz- oder Informationssignals (1k') im zulässigen Bereich unterhalb des Grenzwertes für die Signalgröße des modulierten Trägersignals liegen, und
- ausgehend von einem Wunschsignal (1") unter Durchführung einer Fourier-Transformation (FT, FFT) sowie **durch** Festlegung des zulässigen Amplituden-Spektrums und **durch** Durchführung einer inversen Fourier-Transformation (IFT, IFFT) ist auf Basis der **dadurch** gewonnenen Fundamentalschwingung und den zulässigen Oberschwingungen das digitale Nutz- oder Informationssignal (101) generierbar.

9. Vorrichtung nach Anspruch 8, **dadurch gekennzeichnet, dass** ein Speicher (23) vorgesehen ist, in welchem das korrigierte analoge Nutz- oder Informationssignal (1k') in digitalisierter Form als digitales Nutz- oder Informationssignal (101) hinterlegt ist, aus welchem mittels des Generators (115) das digitalisierte Nutz- oder Informationssignal (101) erzeugbar und in einem nachgeschalteten Digital-Analog-Wandler (25) in ein analoges Nutz- oder Informationssignal (101) wandelbar ist, welches dem Trägersignal (5) aufmoduliert wird.

10. Vorrichtung nach Anspruch 8 oder 9, **dadurch gekennzeichnet, dass** zwischen dem Digital-Analog-Wandler (25) und dem Modulationseingang des Modulators oder Mischers (13) ein Tiefpass (17) vorgesehen ist, über den das im Digital-Analog-Wandler (25) analogisierte Nutz- oder Informationssignal (1) dem Modulator oder Mischer (13) zuführbar ist.

11. Vorrichtung nach einem der Ansprüche 8 bis 10, **dadurch gekennzeichnet, dass** mittels des Generators (115) zur Erzeugung eines digitalisierten Nutz- oder Informationssignals (101) ein Rechtecksignal oder eine einem Rechtecksignal angenäherte Signalform erzeugbar ist.

12. Vorrichtung nach einem der Ansprüche 8 bis 11, **dadurch gekennzeichnet, dass** die Vorrichtung zur Erzeugung eines amplituden-modulierten Signals auf dem Gebiet der RFID-Technik bestimmt und/oder ausgelegt ist.

## Claims

1. Method for generating an amplitude-modulated signal, having the following features:
- a carrier signal (5) is amplitude-modulated with an analogue useful signal or information signal (1),
- the modulated carrier signal is broadcast in a usable band (3) having a predetermined bandwidth,
- the carrier power of the carrier signal (5) is set in such a way that the spectrum of the modulated carrier signal outside the usable band (3) does not exceed a boundary value for the signal amplitude of the modulated carrier signal,
**characterised by** the following further features:
- the useful signal or information signal (1) is generated from a digitised useful signal or information signal (101) which is converted into an analogue useful signal or information signal (1),
- for the useful signal or information signal (1), instead of a desired signal (1") a corrected analogue useful signal or information signal (1k') is used, which is altered by comparison with the desired signal (1 ") in such a way that harmonic waves which are above the boundary value for the signal amplitude of the modulated carrier signal outside the usable band (3) when the desired signal (1 ") is used are in the acceptable range, below the boundary value for the signal amplitude of the modulated carrier signal, when the corrected useful signal or information signal (1k') is used, and
- so as to obtain an acceptable useful signal or information signal (101) in a digitised form, starting from a desired signal (1 "), a Fourier transform (FT, FFT) is carried out, the acceptable amplitude spectrum is established, and an inverse Fourier transform (IFT, IFFT) is carried out, and as a result, the acceptable harmonic oscillations for generating the digital useful signal or information signal (101) can be established, as well as the fundamental oscillation.

2. Method according to claim 1, **characterised in that** the corrected analogue useful signal or information signal (1k') is stored in a digitised form as a digital useful signal or information signal (101) in a memory (23), from which the digitised useful signal or information signal (101) is generated by means of a generator (115) and converted, in a downstream digital/analogue converter (25), into an analogue useful signal or information signal (1), which is modulated up to a carrier signal (5).

3. Method according to either claim 1 or claim 2, **characterised in that** the analogue useful signal or information signal (1) which is obtained from a digitised useful signal or information signal (101) is supplied to a modulator (13) via a deep pass (17).

4. Method according to any one of claims 1 to 3, **characterised in that** a useful signal or information signal (1k'), which is corrected by comparison with the desired signal (1"), is preferably generated once, in the form of a digitised useful signal or information signal (101), and stored in a memory (23), from which subsequently the digitised useful signals or information signals (101) are initially generated, and analogue useful signals or information signals (1) are generated therefrom.

5. Method according to any one of claims 1 to 4, **characterised in that** a further optimisation step is carried out, in which the analogued useful signal or information signal (1) and/or the modulated carrier signal (5) are analysed for acceptable and unacceptable harmonic oscillations, and **in that** the analogued useful signal or information signal (1), after the analogue conversion, is altered in terms of the step form thereof in relation to individual time slot lengths (T_{w}) and/or individual step heights (H), until an improvement is achieved in the modulated carrier signal in relation to acceptable and unacceptable harmonic oscillations, the output data for the digitised useful signal or information signal (101) which are selected for this eventuality being stored as base data for reproducibly generating a corresponding digitised useful signal or information signal (1).

6. Method according to any one of claims 1 to 5, **characterised in that** the useful signal or information signal (101) which is present or is generated in a digitised form consists of a square pulse or a pulse which approximates a square pulse.

7. Method according to any one of claims 1 to 6, **characterised in that** the digitised useful signal or information signal (101) is used as a signal for amplitude modulation in the field of RFID.

8. Device for generating an amplitude-modulated signal, having the following features:
- a generator (11) is provided for generating a carrier signal (5), which is supplied to a modulator or mixer (13) which is preferably connected to an antenna (21),
- a means is provided for generating an analogue useful signal or information signal (1), which is connected at least indirectly to another input of the modulator or mixer (13) for generating an amplitude-modulated carrier signal, the amplitude-modulated carrier signal being generated in such a way that it is transmitted in a usable band (3) and does not exceed a boundary value for the signal amplitude outside the usable band (3),
**characterised by** the following further features:
- a generator (115) is provided for generating a digitised useful signal or information signal (101),
- a digital/analogue converter (25) for converting the digitised useful signal or information signal (101) into an analogue useful signal or information signal (1) is arranged downstream from the generator (115) for generating a digitised useful signal or information signal (101), and is connected directly or indirectly to the modulation input of the modulator or mixer (13),
- a digitised useful signal or information signal (101) is generated by means of the generator (115), and an analogue useful signal or information signal is generated by means of the downstream digital/analogue converter (25) and is altered by comparison with a desired signal (1 ") in such a way that harmonic waves which are above a boundary value for the signal amplitude of the modulated carrier signal outside the usable band when the desired signal (1") is used are in the acceptable range, below the boundary value for the signal amplitude of the modulated carrier signal, when the corrected useful signal or information signal (1k') is used, and
- starting from a desired signal (1 "), by carrying out a Fourier transform (FT, FFT), by establishing the acceptable amplitude spectrum, and by carrying out an inverse Fourier transform (IFT, IFFT), the digital useful signal or information signal (101) can be generated on the basis of the fundamental oscillation which is thereby obtained and the acceptable harmonic oscillations.

9. Device according to claim 8, **characterised in that** a memory (23) is provided, in which the corrected analogue useful signal or information signal (1k') is stored in a digitised form as a digital useful signal or information signal (101), from which the digitised useful signal or information signal (101) can be generated by means of the generator (115) and converted, in a downstream digital/analogue converter (25), into an analogue useful signal or information signal (101), which is modulated up to the carrier signal (5).

10. Device according to either claim 8 or claim 9, **characterised in that** a deep pass (17), via which the useful signal or information signal (1) which is analogued in the digital/analogue converter (25) can be supplied to the modulator or mixer (13), is provided between the digital/analogue converter (25) and the modulation input of the modulator or mixer (13).

11. Device according to any one of claims 8 to 10, **characterised in that** a square signal or a signal form which approximates a square signal can be generated by means of the generator (115) for generating a digitised useful signal or information signal (101).

12. Device according to any one of claims 8 to 11, **characterised in that** the device for generating an amplitude-modulated signal is intended and/or configured for generating an amplitude-modulated signal in the field of RFID.

## Revendications

1. Procédé pour la production d'un signal modulé en amplitude, présentant les éléments techniques suivants :
- un signal porteur (5) est modulé en amplitude avec un signal utile ou un signal d'information (1) analogique,
- le signal porteur modulé est émis dans une bande utile (3) avec une largeur de bande prédéterminée,
- la puissance portante du signal porteur (5) est établie de telle façon que le spectre du signal porteur modulé ne dépasse pas, à l'extérieur de la bande utile (3), une valeur limite pour la taille du signal porteur modulé,
**caractérisé par** les caractéristiques suivantes :
- le signal utile ou signal d'information (1) est produit à partir d'un signal utile ou signal d'information (101) numérisé qui est converti en un signal utile ou signal d'information (1) analogique,
- pour le signal utile ou signal d'information (1) on utilise, au lieu d'un signal souhaité (1") un signal utile ou signal d'information analogique corrigé (1k') qui est modifié par rapport au signal souhaité (1") de telle façon que des ondes harmoniques qui sont, lors de l'utilisation du signal souhaité (1") à l'extérieur de la bande utile (3), situées au-dessus de la valeur limite pour la taille du signal porteur modulé seront, lors de l'utilisation du signal utile ou signal d'information corrigé (1k') dans la zone admissible, situées au-dessous de la valeur limite pour la taille du signal porteur modulé, et
- pour récupérer un signal utile ou signal d'information admissible (101) sous forme numérisée, on exécute une transformation de Fourier (FT, FFT), une détermination du spectre d'amplitude admissible et une transformation de Fourier inverse (IFT, IFFT) d'un signal souhaité, grâce à quoi il est possible de déterminer, outre l'oscillation fondamentale, les oscillations harmoniques admissibles pour la génération du signal utile ou signal d'information numérique (101).

2. Procédé selon la revendication 1, **caractérisé en ce que** le signal utile ou signal d'information analogique corrigé (1k') est mémorisé sous forme numérisée à titre de signal utile ou signal d'information numérique (101) dans une mémoire (23) à partir duquel on engendre au moyen d'un générateur (115) le signal utile ou signal d'information numérisé (101) et on le convertit dans un convertisseur numérique/analogique (25) branché à la suite en un signal utile ou signal d'information analogique (1), lequel est modulé sur un signal porteur (5).

3. Procédé selon la revendication 1 ou 2, **caractérisé en ce que** le signal utile ou signal d'information analogique (1) récupéré à partir du signal utile ou signal d'information numérisé (101) est amené à un modulateur (13) via un filtre passe-bas (17).

4. Procédé selon l'une des revendications 1 à 3, **caractérisé en ce qu'**un signal utile ou signal d'information (1k') corrigé par rapport au signal souhaité (1") est engendré sous la forme d'un signal utile ou signal d'information numérisé (101), de préférence une seule fois et est mémorisé dans une mémoire (23), à partir duquel on génère successivement tout d'abord les signaux utiles ou signaux d'information numérisés (101) et à partir de ceux-ci des signaux utiles ou signaux d'information analogiques (1).

5. Procédé selon l'une des revendications 1 à 4, **caractérisé en ce que** l'on exécute une autre étape d'optimisation dans laquelle le signal utile ou signal d'information analogique (1) et/ou le signal porteur modulé (5) font l'objet de recherches à l'égard d'oscillations harmoniques admissibles et inadmissibles, et **en ce que** le signal utile ou signal d'information analogique (1) est modifié, après la conversion analogique, pour ce qui concerne sa forme en gradins à l'égard de longueurs individuelles de fenêtres temporelles (T_{w}) et/ou de hauteurs de gradins individuelles (H) jusqu'à atteindre une amélioration pour ce qui concerne le signal porteur modulé à l'égard d'oscillations harmoniques admissibles et inadmissibles, et les données de départ choisies pour ce cas pour le signal utile ou signal d'information numérisé (101) sont mémorisées à titre de données de base pour générer de façon reproductible un signal utile ou signal d'information numérisé correspondant (1).

6. Procédé selon l'une des revendications 1 à 5, **caractérisé en ce que** le signal utile ou signal d'information (101) qui se présente ou qui est engendré sous forme numérisée est une impulsion rectangulaire ou une impulsion approximativement rectangulaire.

7. Procédé selon l'une des revendications 1 à 6, **caractérisé en ce que** le signal utile ou signal d'information numérisé (101) est utilisé comme signal pour la modulation en amplitude dans le domaine des techniques RFID.

8. Dispositif pour produire un signal modulé en amplitude, présentant les éléments techniques suivants :
- il est prévu un générateur (11) pour produire un signal porteur (5), lequel est amené à un modulateur ou mélangeur (13), qui est de préférence relié à une antenne (21),
- il est prévu un moyen pour produire un signal utile ou signal d'information analogique (1), ce moyen étant connecté au moins indirectement à une autre entrée du modulateur ou mélangeur (13) pour produire un signal porteur modulé en amplitude, ledit signal porteur modulé en amplitude étant produit de telle façon qu'il est transmis à l'intérieur d'une bande utile (3) et ne dépasse pas une valeur limite pour la taille du signal à l'extérieur de la bande utile (3),
**caractérisé par** les autres caractéristiques suivantes :
- il est prévu un générateur (115) pour produire un signal utile ou signal d'information numérisé (101),
- un convertisseur numérique/analogique (25), destiné à convertir le signal utile ou signal d'information numérisé (101) en un signal utile ou signal d'information analogique (1), est branché à la suite du générateur (115) destiné à produire un signal utile ou signal d'information numérisé (101), ce convertisseur étant connecté directement ou indirectement à l'entrée de modulation du modulateur ou mélangeur (13),
un signal utile ou signal d'information numérisé (101) est produit au moyen du générateur (115), et au moyen du convertisseur numérique/analogique (25) branché à la suite un signal utile ou signal d'information analogique est produit, lequel est modifié par rapport à un signal souhaité (1") de telle façon que des ondes harmoniques qui sont, lors de l'utilisation du signal souhaité (1") à l'extérieur de la bande utile (3), situées au-dessus d'une valeur limite pour la taille du signal porteur modulé seront, lors de l'utilisation du signal utile ou signal d'information corrigé (1k') dans la plage admissible, situées au-dessous de la valeur limite pour la taille du signal porteur modulé, et
- partant d'un signal souhaité (1"), en exécutant une transformation de Fourier (FT, RST), en déterminant le spectre d'amplitude admissible et en exécutant une transformation de Fourier inverse (IFT, IFFT), le signal utile ou signal d'information numérique (101) peut être généré en se basant sur l'oscillation fondamentale et sur les oscillations harmoniques admissibles ainsi récupérées.

9. Dispositif selon la revendication 8, **caractérisé en ce qu'**il est prévu une mémoire (23) dans laquelle le signal utile ou signal d'information analogique corrigé (1k') est mémorisé sous forme numérisée à titre de signal utile ou signal d'information numérique (101), à partir duquel il est possible de produire le signal utile ou signal d'information numérisé (101) au moyen du générateur (115) et le convertir en un signal utile ou signal d'information analogique (101) dans un convertisseur numérique/analogique (25) branché à la suite, qui est modulé sur le signal porteur (5).

10. Dispositif selon la revendication 8 ou 9, **caractérisé en ce que**, entre le convertisseur numérique/analogique (25) et l'entrée de modulation du modulateur ou mélangeur (13), il est prévu un filtre passe-bas (17) via lequel le signal utile ou signal d'information (1), rendu analogique dans le convertisseur numérique/analogique (25), peut être amené au modulateur ou mélangeur (13).

11. Dispositif selon l'une des revendications 8 à 10, **caractérisé en ce que**, au moyen du générateur (115) destiné à produire un signal utile ou signal d'information numérisé (101), il est possible de produire un signal rectangulaire ou un signal d'une forme approchée à un signal rectangulaire.

12. Dispositif selon l'une des revendications 8 à 11, **caractérisé en ce que** le dispositif pour produire un signal modulé en amplitude est destiné et/ou conçu pour le domaine des techniques RFID.
